# EUROPÄISCHE PATENTSCHRIFT

(11) **EP 2 187 434 B1**
(45) Veröffentlichungstag und Bekanntmachung des Hinweises auf die Patenterteilung: **05.03.2014**
(21) Anmeldenummer: 09176185.8
(22) Anmeldetag: 17.11.2009
(51) Int. Cl.: G03F 7/20, H01L 21/68

(54) **Aerostatisch geführtes Tischsystem für die Vakuumanwendung**
Aerostatically guided table system for vacuum application
Système de table commandé de manière aérostatique pour l'utilisation sous vide

(30) Priorität: 17.11.2008 DE 102008058306
(43) Veröffentlichungstag der Anmeldung: 19.05.2010
(73) Patentinhaber: Vistec Electron Beam GmbH, 07745 Jena (DE)
(72) Erfinder: Schubert, Gerhard, 07749, Jena (DE); Jackel, Christian, 06722, Droyssig (DE); Kirschstein, Ulf-Carsten, 07751, Jena (DE); Böhm, Michael, 07749, Jena (DE); Bauer, René, 07745, Jena (DE); Harnisch, Gerd, 07749, Jena (DE); Dr. Peschel, Thomas, 07743, Jena (DE); Dr. Risse, Stefan, 07749, Jena (DE); Dr. Schenk, Christoph, 07747, Jena (DE)
(74) Vertreter: Freitag, Joachim

(56) Entgegenhaltungen:
- WO-A2-2008/001069
- JP-A- 59 101 834
- JP-A- 2001 052 988
- US-A- 5 140 242
- US-A1- 2002 034 345
- US-A1- 2008 166 213
- US-B1- 6 324 933

## Beschreibung

Die Erfindung betrifft ein Tischsystem für die Vakuumanwendung nach dem Oberbegriff des Hauptanspruchs.

Derartige Tischsysteme sind allgemein bekannt, beispielsweise aus der EP 1 235 115 A2 und der US 5 499 880 B2. Die aus diesen Druckschriften bekannten vakuumtauglichen gas-oder luftgeführten Tische bestehen üblicherweise aus zwei Achsen, beispielsweise in x- und y-Richtung ausgerichtet, die sich unter Hochvakuumbedingungen bewegen können, wobei für eine nahezu reibungsfreie Bewegung beispielsweise auf einer festen Grundplatte Gas- bzw. Luftlagerelemente verwendet werden. Üblicherweise sind entlang der einen Achse, z. B. der x-Achse, Schlitten auf Führungsschienen, z, B. in Form von Balken, bewegbar, und zwischen diesen Schlitten ist eine Verbindungsschiene, z. B. in Form eines Querbalkens, in Richtung der anderen Achse angeordnet, an der bzw. dem ein weiterer Schlitten läuft, der eine Tischplattenanordnung trägt.

Ein weiteres Tischsystem mit linearen Führungen, deren Bewegungen entlang der kartesische Kanten des Tisches ausgerichtet sind, ist in der US 6 324 933 B2 offenbart. Dabei wird die Beweglichkeit des Tisches bei Anordnung der Luftlager in einer Ebene durch Biegegelenke der Schubstangen erreicht, wodurch sich eine Vereinfachung der Gaszu- und -abfuhr für die Luftlager unter Vakuumbedingungen ergibt.

Aus der US 5 140 242 A ist ein Tischsystem mit drei drehbaren Antrieben bekannt, bei dem ein Verfahrtisch mit drei Antriebsstangen dreh- bzw. schwenkbar verbunden ist, die jeweils von einer mit einem Motor verbundenen Antriebsrolle und Andruckrollen bewegt werden.

Eine weitere Lösung zur Manipulation eines Substrats in beliebigen Freiheitsgraden ist in der US 2008/0166213 A1 offenbart. Der beschriebene Tisch wird mit mindestens drei Aktuatoren, die entlang der Kanten eines Dreiecks beweglich sind, über je einen Gelenkarm angetrieben, wobei die Gelenkarme sowohl am Tisch als auch am Aktuator mittels Drehgelenken angekoppelt sind, wodurch beliebige Tischbewegungen ausführbar, aber vakuumtechnisch schwer beherrschbar sind.

Der Erfindung liegt die Aufgabe zugrunde, ein Tischsystem für die Vakuumanwendung zu schaffen, das eine zum Stand der Technik neue Art der Parallelkinematik des Antriebssystems mit einer reduzierten Leckrate der aerostatischen Lagereinheiten aufweist und eine genaue Positionierung gestattet. Insbesondere sollen sich durch eine geringere bewegte Masse, ohne Nachteile für die Steifigkeit, Vorteile in der Dynamik des Systems ergeben, die dem klassischen seriellen kinematischen Ansatz überlegen sind.

Diese Aufgabe wird erfindungsgemäß durch ein Tischsystem für die Vakuumanwendung mit den Merkmalen des Hauptanspruchs gelöst.

Durch die in den Unteransprüchen angegebenen Maßnahmen sind vorteilhafte Weiterbildungen und Verbesserungen möglich.

Dadurch, dass die aerostatischen lagereinheiten des Tischsystems zumindest teilweise als Drehgelenke ausgebildet sind und mit dem um die Z-Achse drehenden Teil jedes Drehgelenks eine von einem Antrieb betätigte Schubstange zur lateralen Führung des Verfahrtisches in X- und Y-Richtung verbunden ist und die Schubstangen hohl und Bestandteil der Absaugleitungen zum Abführen des Betriebsgases für die aerostatischen Lagereinheiten sind, wird ein Koppelgetriebe in Form einer Parallelkinematik gebildet, wodurch eine genaue Positionierung des Verfahrtisches, der sich durch in die aerostatischen Lagereinheiten integrierte aerostatische Lagerelemente gegen eine Basisstruktur abstützt, an gewünschter Stelle möglich ist. Durch die Ableitung der abgesaugten Gase über die Schubstangen, deren freie Enden vorteilhafterweise in zweiten Vakuumkammern, den Nebenkammem, enden, die durch eine Dichtung druckmäßig von der ersten Vakuumkammer mit Verfahrtisch der Hauptkammer, getrennt sind und über die das aus den Schubstangen strömende Gas mit angeschlossenen Vakuumpumpen abgezogen wird, können kurze Absaugleitungslängen umgesetzt und die Übertragung von Zwangskräften durch Rohrleitungen auf den Verfahrtisch vermieden werden.

Vorteilhafterweise sind genau drei als Drehgelenke und Führungselemente wirkende aerostatische Lagereinheiten an einer verwindungssteifen Rahmenkonstruktion angebracht. Die Drehgelenke weisen dabei jeweils ein bezogen auf die Rahmenkonstruktion feststehendes Teil, z.B. in Doppel-T-Form, im axialen Querschnitt gesehen, auf, und das drehbare Teil ist ein um den mittleren Bereich als Achsenteil herum angeordneter drehbarer Ring, der mindestens radial, vorteilhafterweise radial und axial zum feststehenden Teil über aerostatische Lager mit angeschlossenem Dichtsystem gelagert ist. Durch eine Anordnung je eines aerostatischen Axiallagers zu beiden Stirnseiten des drehbaren Rings wird dieser innerhalb der Lagereinheit mit sehr hoher axialer Steifigkeit aufgenommen, da sich die Axiallager gegenseitig vorspannen. Somit werden durch eine aerostatische Lagereinheit in vorteilhafter Weise mehrere Funktionen ausgeführt. Die Absaugkanäle des Dichtsystems der jeweiligen aerostatischen Lagerelemente sind innerhalb der Lagereinheiten über Leitungen verbunden, wodurch ein kompakter Aufbau erreicht wird.

Vorteilhafterweise führen bei zweistufigen Dichtsystemen zum Abdichten gegen unterschiedliche Drücke zwei Schubstangen das Gas mit niedrigerem Druck und eine Schubstange das Gas mit höherem Druck. Dies ermöglicht eine Verdoppelung des Saugvermögens der Absaugstufe mit niedrigerem Druck, was sich positiv auf die Leckrate der aerostatischen Lagereinheiten auswirkt. Durch diese Maßnahmen wird der Aufwand an Rohrleitungen optimiert. Es ist jedoch auch möglich, die dritte Schubstange zu anderen Zwecken als zum Abführen des Betriebsgases zu nutzen, z. B. um andere Medien dem Verfahrtisch zuzuführen. Auch ein Aufteilen einzelner Schubstangen in mehrere Leitungen ist möglich, um dem Verfahrtisch andere Medien zuzuführen.

In besonders vorteilhafter Weise ist jede Schubstange über ein eine Drehung und eine Torsion zulassendes Koppelelement mit dem drehbaren Teil, d. h. dem mittleren Ring der Lagereinheit verbunden, da auf diese Weise die Übertragung ungewollter Bewegungen auf den Verfahrtisch, die durch Toleranzen bei der Fertigung der Schubstange und des Antriebes sowie bei der Ausrichtung des Antriebs zum Verfahrtisch hervorgerufen werden, vermieden wird. Dabei beinhaltet das Koppelelement ein Dreh- und ein Torsionsgelenk.

In einer besonders vorteilhaften Ausführungsform ist an der der Basisplatte zugewandten Seite der Rahmenkonstruktion eine vorzugsweise elektrostatische Vorspannvorrichtung zum Aufbringen einer zwischen Vorspannvorrichtung und Basisplatte wirkenden Kraft angeordnet. Aufgrund dieser Vorspannvorrichtung können bessere statische und dynamische Eigenschaften des Verfahrtisches erzielt werden.

Für den Antrieb jeder Schubstange ist ein von einem Motor angetriebenes drehbar gelagertes Reibradgetriebe vorgesehen, das vorteilhafterweise gleichzeitig zur Lagerung oder Führung der Schubstange dient.

Die vorliegende Erfindung sieht vor, dass der Verfahrtisch mit aerostatischen Lagereinheiten und die Basisplatte sowie ein Teil der Schubstangen in einer ersten Vakuumkammer, der Hauptkammer aufgenommen sind und die Antriebe, z.B. Reibradantriebe, zumindest teilweise zwischen der ersten Hauptkammer und zweiten Vakuumkammern, den Nebenkammern, höheren Drucks angeordnet sind.

Wie schon erwähnt, ragen die freien Enden der Schubstangen in die Nebenkammern, die Bestandteil der Absaugung der aerostatischen Lagereinheiten des Verfahrtisches sind und an die jeweils eine Vakuumpumpe zum Abpumpen des aus den Schubstangen in die Nebenkammern strömenden Gases angeschlossen ist. Flexible Verbindungsleitungen zwischen den freien Enden der Reibstangen und den zur Absaugung des Betriebsgases benötigten Vakuumpumpen sind nicht erforderlich. Dadurch wird das Übertragen von Zwangskräften über die Absaugleitungen auf den Verfahrtisch vermieden.

Für die Abdichtung der Hauptkammer zu den Nebenkammern sind vorteilhafterweise dynamische Spaltdichtungen mit dazwischen angeordneten Absaugstufen vorgesehen, die zwischen einem äußeren und einem inneren zylinderförmigen Gehäuseteil des Reibradgetriebes, die zueinander drehbar gelagert sind, als einstufiges oder zweistufiges Dichtsystem angeordnet sind.

Ein Ausführungsbeispiel der vorliegenden Erfindung
ist in der Zeichnung dargestellt und wird in der nachfolgenden Beschreibung näher erläutert. Es zeigen
- Fig. 1: eine perspektivische Darstellung des erfindungsgemäßen Tischsystems,
- Fig. 2: eine perspektivische Ansicht des Verfahrtisches des erfindungsgemäßen Tischsystems von unten,
- Fig. 3: eine perspektivische Schnittdarstellung einer aerostatischen Lagereinheit mit integriertem Drehgelenk, die bei dem erfindungsgemäßen Tischsystem verwendet wird,
- Fig. 4: eine perspektivische Ansicht auf eine Lagereinheit nach Fig. 3 mit Koppelelement zu einer Schubstange,
- Fig. 5: eine Prinzipdarstellung eines Teils des Reibradgetriebes mit Reibrad und Lagerung und
- Fig. 6: eine schematische Darstellung auf ein Reibradgetriebe mit Teil einer Schubstange in Aufsicht.

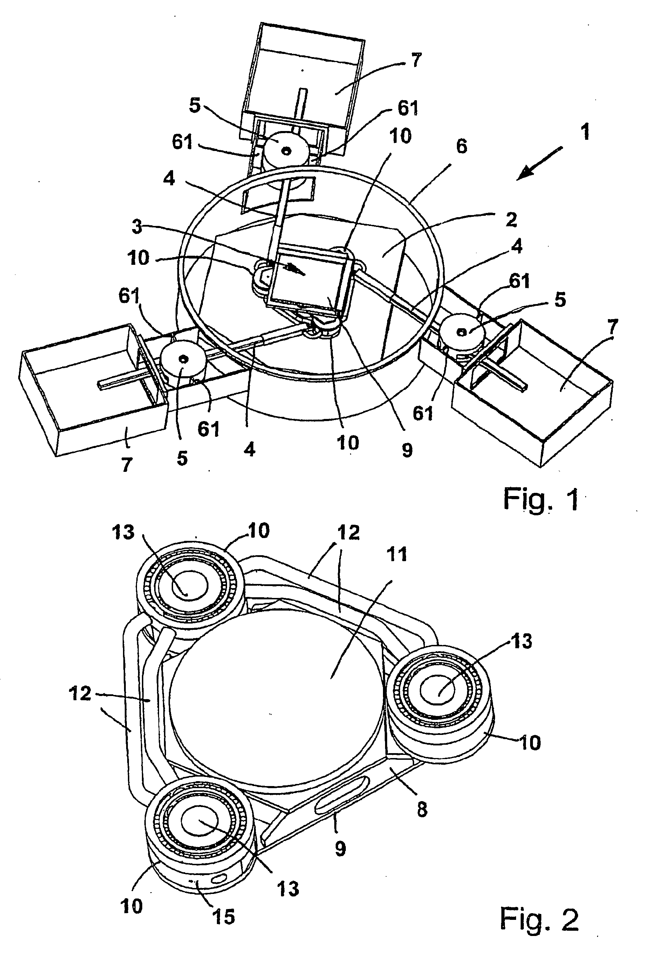

Das in Fig. 1 dargestellte Tischsystem 1 umfasst eine Basisplatte 2, einen auf der Basisplatte 2 gasgeführten Verfahrtisch 3 und ein Führungs- und Antriebssystem, das aus drei an den Verfahrtisch 3 angreifenden Schubstangen 4 mit zugehörigen Antrieben 5 besteht, wobei die Motoren der Antriebe nicht näher dargestellt sind. Basisplatte 2, Verfahrtisch 3 und teilweise die Schubstangen 4 sind in einer als Hauptkammer bezeichneten ersten Vakuumkammer 6 aufgenommen, während die Antriebe 5 zumindest teilweise in einer als Nebenkammern 7 bezeichneten zweiten Vakuumkammern liegen, von denen, entsprechend der Zahl der Antriebe 5, drei vorhanden sind. Innerhalb der Nebenkammern 7 herrscht ein Druck, der näher am atmosphärischen Druck liegt als der Druck in der Hauptkammer 6. Die Enden der Schubstangen 4 ragen in die Nebenkammer 7 hinein. Die Nebenkammer 7 ist jeweils mit einer nicht dargestellten Vakuumpumpe zum Absaugen von Gas verbunden.

Die Basisplatte 2 ist als eine an dem Boden der ersten zylinderförmigen Vakuumkammer bzw. Hauptkammer 6 montierte Keramikplatte mit einer ebenen bearbeiteten Fläche als Referenz des Verfahrtisches 3 in Z-Richtung ausgeführt. Der Verfahrtisch 3 umfasst eine verwindungssteife dreieckige Rahmenkonstruktion 8, an der eine Tischplatte 9, drei aerostatische Lagereinheiten 10 und eine Vorspanneinheit 11, z. B. eine elektrostatische Vorspanneinheit, befestigt sind (s. Fig. 2). Die aerostatischen Lagereinheiten 10 sind untereinander über Absaugleitungen 12 für zwei Absaugstufen verbunden, wie weiter unten näher erläutert wird.

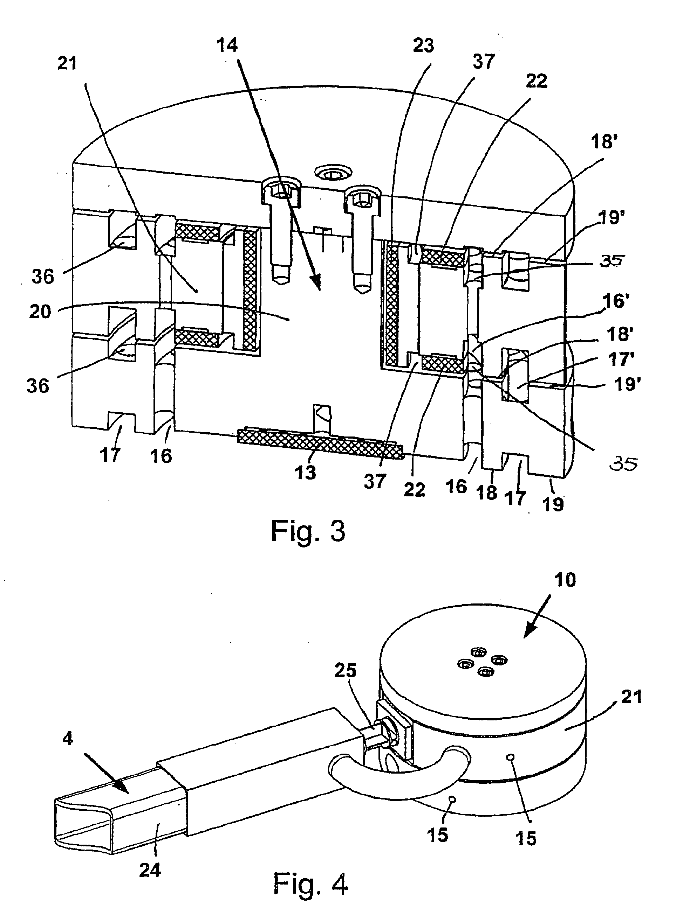

Die an den drei Ecken des Rahmens 8 montierten aerostatischen Lagereinheiten 10 sind in Fig. 3 dargestellt, die einen Schnitt in Z-Richtung beim größten Durchmesser der Lagereinheiten 10 zeigt. Die im Ausführungsbeispiel zylinderförmige aerostatische Lagereinheit 10 weist an ihrer der Basisplatte 2 zugewandten Unterseite ein planes aerostatisches Lagerelement 13 als tragendes Element der Lagereinheit 10 auf, unter dem sich der tragende Luft- oder Gasfilm ausbildet. Das aerostatische Lagerelement 13 ist mit nicht dargestellten Gaszuführungsleitungen verbunden, die durch den Grundkörper 14 der Lagereinheit 10 geführt sind, wobei die Verbindungsanschlüsse 15 für das über flexible Schlauchleitungen zu den Lagereinheiten geführte Betriebsgas auf der Seite des Grundkörpers 14 (Fig. 4) zu erkennen sind. Das unter Druck stehende Betriebsgas wird z. B. über ein poröses Material oder einzelne Düsen, die Bestandteil des Gaslagerelements 13 sind, in einen Spalt zwischen aerostatischem Lagerelement 13 und Basisplatte 2 verteilt. Das aerostatische Lagerelement 13 wird von einem ersten Absaugkanal 16 und einem zweiten Absaugkanal 17 umgeben. Zwischen den Absaugkanälen 16, 17 und angrenzend an den Absaugkanal 17 sind eine erste und eine zweite Dichtfläche 18, 19 vorgesehen, die zusammen in Verbindung mit der Basisplatte 2 ein zweistufiges Dichtsystem aus zwei Absaugkanälen und zwei Dichtspalten bilden. Der erste Absaugkanal 16 und der erste Dichtspalt mit Dichtfläche 18 dienen als erste Absaugstufe für ein erstes Vakuum, das im Druckbereich zwischen 10³ Torr und 10⁻² Torr ausgebildet ist, und der zweite Absaugkanal 17 und der zweite Dichtspalt mit Dichtfläche 19 dienen als zweite Absaugstufe für ein zweites Vakuum in einem Druckbereich von 10⁻¹ Torr bis 10⁻⁶ Torr.

Innerhalb der aerostatischen Lagereinheit 10 ist gleichzeitig ein aerostatisches Drehgelenk ausgebildet. Zu diesem Zweck ist der Grundkörper 14 in Doppel-T-Form realisiert, wobei der Mittelteil 20 als Achsenteil für einen drehbaren Ring 21 dient. Der drehbare Ring 21 ist radial über eine aerostatische Lagerbuchse 23 und axial über ringförmige aerostatische Lagerelemente 22 gelagert, wobei für die Axiallager ebenfalls ein zweistufiges Dichtsystem mit Absaugkanälen 16', 17' und Dichtspalten 18', 19' entsprechend dem oben, im Zusammenhang mit dem aerostatischen Lagerelement 13 beschriebenen Dichtsystem vorgesehen ist. Die aerostatischen Lagerelemente 22 und die Lagerbuchsen 23 sind wiederum mit nicht dargestellten Gaszuführungsleitungen verbunden, die durch den Grundkörper 14 der Lagereinheit 18 geführt sind. Die Absaugkanäle 16', 17' sind innerhalb der Lagereinheit 10 über Verbindungsbohrungen 35, 36 mit den Absaugkanälen 16, 17 sowie mit den Rohrleitungen 12 verbunden. Vorteilhafterweise ist zwischen der Lagerbuchse 23 und Axiallagern 22 ein weiterer Absaugkanal 37 ausgebildet, der mit den Absaugleitungen bzw. Kanälen der ersten Absaugstufe oder über eine flexible Leitung mit Normalatmosphäre verbunden sein kann.

Wie aus den Fign. 1 und 2 zu erkennen ist, stützen sich die aerostatischen Lagerelemente 13 der drei aerostatischen Lagereinheiten 10 auf der Basisplatte 2 ab und nehmen die Last des Verfahrtisches in Z-Richtung auf. Um bessere statische und dynamische Eigenschaften für den Verfahrtisch zu erzielen, ist die an der Unterseite des Rahmens 8 befestigte elektrostatische Vorspanneinheit 11 vorgesehen, die die aerostatischen Lagerelemente 13 des Verfahrtisches aufgrund einer zwischen Vorspanneinheit 11 und Basisplatte wirkenden elektrostatischen Kraft vorspannt. Ebenso sind auch auf anderen physikalischen Prinzipien beruhende Vorspanneinheiten denkbar. Die Vorspanneinheit 11 ist hier mittig zwischen den Lagereinheiten 10 angeordnet, es ist jedoch auch denkbar, dass mehrere Vorspanneinheiten vorgesehen sind, die jeweils einem Lagerelement zugeordnet sind. Zur Erzielung der elektrostatischen Kraft ist ein Elektrodensystem vorgesehen, wobei zwei auf unterschiedlichem Potential liegende Elektroden selbst in oder an der plattenförmigen Vorspanneinheit angeordnet sein können oder eine der Elektroden als Gegenelektrode von der Basisplatte 2 gebildet wird, derart, dass die Einheit als Plattenkondensator wirkt.

Die laterale Führung des Verfahrtisches 3 wird durch die drei Schubstangen 4 erreicht, die entsprechend Fig. 4 an die mittleren Ringe 21 der aerostatischen Lagereinheiten 10 angekoppelt sind. Die Schubstangen 4 bestehen aus einem hohlen Keramikrohr 24 mit rechteckigem oder quadratischem Querschnitt sowie einem Koppelelement 25, das an dem Ring 21 über ein Dreh- und ein Torsionsgelenk in Form von Festkörpergelenken befestigt ist. Das Drehgelenk des Koppelelements 25 ermöglicht eine Drehung um eine Achse parallel zur x-y-Ebene und senkrecht zur Längsachse der Schubstange 4, das Torsionsgelenk die Drehung um eine Achse parallel zur Längsachse der Schubstange 4. Durch die hohlen Schubstange 4 gelangt das aus den Lagereinheiten 10 abgesaugte Betriebsgas in die Nebenkammern 7, wobei eine der Schubstangen das Gas der ersten Absaugstufe und zwei der Schubstangen das Gas der zweiten Absaugstufe leiten. Das Gas strömt durch die offenen Enden der Schubstangen 4 frei in die Nebenkammern 7 und wird dort mittels Vakuumpumpen abgepumpt.

In einer weiteren, nicht dargestellten Ausführungsform ist innerhalb der hohlen Schubstange 4 zusätzlich ein Rohr, das vorzugsweise als starres Rohr ausgebildet ist, zur Zuleitung des Betriebsgases angeordnet.

Die drei Schubstangen 4 werden jeweils separat von den Antrieben 5 angetrieben, wobei an der Position des Antriebs 5 die jeweilige Schubstange gelagert oder geführt wird. Sie bilden in Verbindung mit dem Verfahrtisch 3 ein Koppelgetriebe (Parallelkinematik). Befindet sich der Verfahrtisch 3 in der Mitte des Verfahrbereichs (Fig. 1), sind die Schubstangen 4 tangential zum Teilkreis der Lagereinheiten des Verfahrtischs 3 angeordnet und bilden zueinander einen Winkel von 120°. Es sind aber auch andere Anordnungen der Schubstangen möglich. Die Antriebe 5 sind fest an der Vakuumkammer 7 montiert, wobei die zugeordneten Motoren sich außerhalb der Vakuumkammern 6, 7 befinden können, und das eigentliche Getriebe des Antriebs 5, das hier als Reibradgetriebe ausgebildet ist, innerhalb der Vakuumkammern 6, 7 liegt. Die Antriebswelle des Motors ist beim Übergang von Normalatmosphäre zum Vakuum mittels einer ferrofluidisch gedichteten Durchführung abgedichtet.

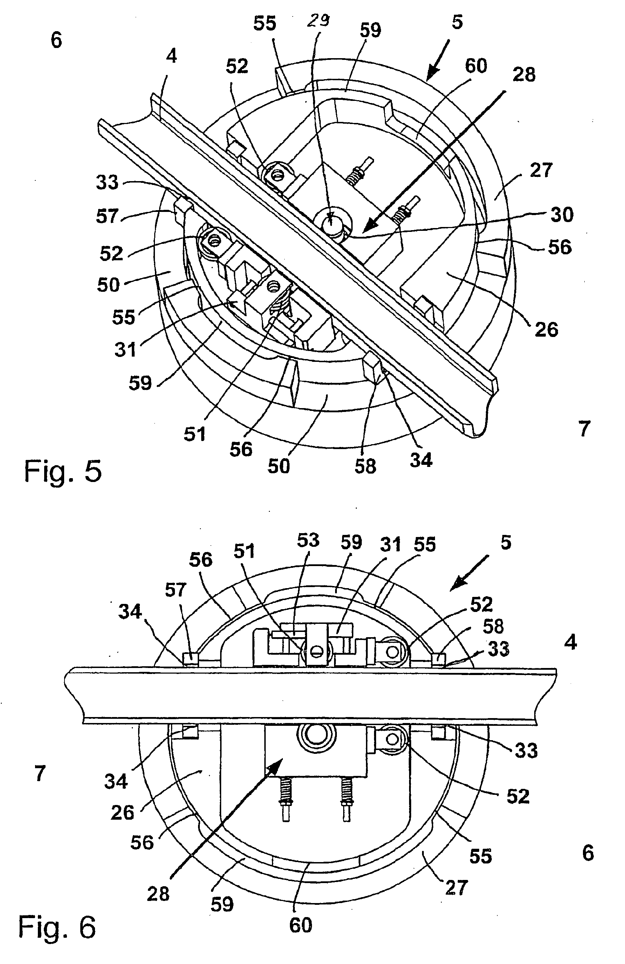

In Fig. 5 und 6 ist ein für den Antrieb 5 verwendetes Reibradgetriebe dargestellt, das zwei ineinander verschachtelte Gehäuseteile 26, 27 umfasst. Das innere Gehäuseteil 26 ist zylinderförmig ausgebildet und im äußeren Gehäuseteil 27 drehbar gelagert. Im inneren Gehäuseteil 26, das von der Schubstange 4 durchgriffen wird, ist die eigentliche Reibradanordnung 28 befestigt. Vorteilhafterweise sind das Reibrad 30 und die Antriebswelle 29, an die der Motor gekoppelt ist, als ein Teil ausgebildet. Bei Bewegung des Verfahrtisches 3 dreht sich das innere Gehäuseteil 26 im äußeren Gehäuseteil 27, wobei im äußeren Gehäuseteil entsprechend dem Schwenkweg der Schubstangen 4 Aussparungen 50 für die Schubstangen 4 vorgesehen sind, die mit dem inneren Gehäuseteil 26 um das Reibrad 30 schwenken. Am inneren Gehäuseteil 26 des Reibradgetriebes sind Kugellager 52 angeordnet, die die Drehung des inneren Gehäuseteils des Reibradgetriebes mit der Schubstange 4 sicherstellen. Die erforderliche Andruckkraft der Schubstange 4 an das Reibrad 30 wird durch ein an die Schubstange 4 angefedertes Druckelement 31 mit Radialkugellagern 51 erreicht (s. Fig. 5). Das Druckelement 31 ist am inneren Gehäuseteil 26 mittels Festkörpergelenken 53 montiert und besitzt den Freiheitsgrad in Richtung der Andruckkraft. Die anderen Freiheitsgrade sind weitgehend gesperrt. Dadurch wird erreicht, dass die Schubstange 4 in Z-Richtung gelagert ist. Bei diesem Prinzip der Lagerung wirkt die Gewichtskraft der Schubstange 4 als Wechsellast auf den Verfahrtisch 3. Sie ist abhängig von dem Abstand der jeweiligen Lagerstellen (Reibradgetriebe und aerostatische Lagereinheit) bzw. Schubstangenposition. Zur Vermeidung der Übertragung ungewollter Bewegungen auf den Verfahrtisch 3 ist das oben beschriebene Koppelelement 25 vorgesehen.

Ein anderes Ausführungsbeispiel sieht eine Führung der Schubstange 4 innerhalb der Antriebseinheit vor. Dabei wird die Schubstange 4 zu beiden Seiten der Reibanordnung 28 in einem Abstand zur Antriebswelle 29 von jeweils zwei Kugellagern im Umgriff in Z-Richtung gestützt. Bei diesem Prinzip wirkt nur noch ein weit geringerer Teil der Gewichtskraft der Schubstange 4 als Wechsellast auf den Verfahrtisch 3. Das Koppelelement 25 zwischen Schubstange 4 und aerostatischer Lagereinheit 10 muss bei dieser Lösung um ein weiteres Drehgelenk parallel und im Abstand zum ersten erweitert werden, um einen Versatz zwischen der Achse der Schubstange und dem Ankoppelpunkt des Koppelelements 25 an der Lagereinheit 10 ausgleichen zu können.

Das innere Gehäuseteil 26 des Reibradgetriebes ist in dem äußeren Gehäuseteil 27 ebenfalls über nicht näher dargestellte Lagerelemente, die sich vorzugsweise außerhalb des Vakuums befinden, drehbar gelagert, wobei zwischen den Gehäuseteilen ebenfalls ein Dichtsystem vorgesehen ist. Dabei entstehen Dichtspalte 55 zwischen der inneren Wand des Gehäuseteil 27 und der äußeren Wand des inneren Gehäuseteils 26. Diese Spaltdichtungen 55 bilden ein einstufiges Dichtsystem und dienen zur Abdichtung der jeweiligen Nebenkammer 7 zu der Hauptkammer 6. Weiterhin sind Spaltdichtungen 33 für die Längsbewegung der Schubstange 4 vorgesehen, wobei Dichtelemente 57 jeweils auf der Seite der Hauptkammer 6 am inneren Gehäuseteil 26 befestigt sind. In das Dichtelement 57 ist eine Innenkontur eingearbeitet, die der Außenkontur des Querschnitts der Schubstange 4 zuzüglich der Größe des Dichtspaltes 33 entspricht.
Falls die Druckdifferenz zwischen der Hauptkammer 6 und der Nebenkammer 7 zu einer zu hohen Einströmung aus der Nebenkammer 7 in die Hauptkammer 6 führt, wird anstelle des einstufigen Dichtsystems zwischen den Kammern ein zweistufiges Dichtsystem zur Abdichtung eingesetzt. Am inneren Gehäuseteil 26 wird auf der Seite der Nebenkammer 7 ein zusätzliches Dichtelement 58 befestigt, durch das eine weitere Spaltdichtung 34 für die Längsbewegung der Schubstange 4 ausgebildet wird. Zwischen innerem Gehäuseteil 26 und äußerem Gehäuseteil 27 wird ebenfalls eine weitere Spaltdichtung 56 eingeführt. Zwischen den Spaltdichtungen 55, 56 befindet sich ein Absaugkanal 59, der über eine Öffnung 60 mit dem Innenraum des inneren Gehäuseteils 26 verbunden ist. Auf diese Weise ist der Innenraum des inneren Gehäuseteils 26 sowohl gegenüber der Hauptkammer 6 als auch gegenüber der Nebenkammer 7 durch Spaltdichtungen 33, 57; 34, 58, abgedichtet, so dass eine dritte Vakuumkammer als Zwischenkammer zwischen Haupt- und Nebenkammer 6, 7 geschaffen wird, die den inneren Bereich des inneren Gehäuseteils 26 umfasst und über eine separate Pumpe evakuiert werden kann.

Das äußere Gehäuseteil 27 ist innerhalb der Nebenkammer 7 statisch, d.h. durch Wände 61 (Fig. 1) zur Hauptkammer 6 abgedichtet.

### Bezugszeichenliste

- 1: Tischsystem
- 2: Basisplatte
- 3: Verfahrtisch
- 4: Schubstange
- 5: Antrieb
- 6: erste Vakuumkammer, Hauptkammer
- 7: zweite Vakuumkammer, Nebenkammer
- 8: Rahmenkonstruktion
- 9: Tischplatte
- 10: aerostatische Lagereinheit
- 11: Vorspanneinheit
- 12: Absaugleitung
- 13: planes aerostatisches Lagerelement
- 14: Grundkörper
- 15: Verbindungsanschlüsse
- 16, 16': erster Absaugkanal
- 17, 17': zweiter Absaugkanal
- 18, 18': erste Dichtfläche, Dichtspalt
- 19, 19': zweite Dichtfläche, Dichtspalt
- 20: Mitteilteil
- 21: drehbarer Ring
- 22: ringförmiges aerostatisches Lagerelement
- 23: Lagerbuchse
- 24: hohles Keramikrohr
- 25: Koppelelement
- 26: innerer Gehäuseteil
- 27: äußerer Gehäuseteil
- 28: Reibradanordnung
- 29: Antriebswelle
- 30: Reibrad
- 31: Druckelement
- 33: Spaltdichtungen
- 34: Spaltdichtungen
- 35: Verbindungsbohrungen
- 36: Verbindungsbohrungen
- 37: Absaugkanal
- 50: Aussparung
- 51: Radialkugellager
- 52: Kugellager
- 53: Festkörpergelenke
- 55: Dichtspalte
- 56: Spaltdichtung
- 57: Dichtelement
- 58: Dichtelement
- 59: Absaugkanal
- 60: Öffnung
- 61: Wände

## Patentansprüche

1. Tischsystem für die Vakuumanwendung mit einer Basisplatte und einem über aerostatische Lagereinheiten geführten Verfahrtisch, wobei die Lagereinheiten mit Zufuhr- und Absaugleitungen zum Zuführen und Abführen des zum Betrieb der Lagereinheiten benötigten Betriebsgases verbunden sind und jeweils mit einem zumindest einstufigen Dichtsystem aus Absaugkanal und Dichtspalt zur Abdichtung der Lagereinheiten zum Vakuum hin versehen sind, **dadurch gekennzeichnet, dass**
- mindestens drei separate aerostatische Lagereinheiten (10), die jeweils separate Dichtsysteme mit ringförmigen Absaugkanälen und Dichtspalten aufweisen, an der Peripherie des Verfahrtisches (3) befestigt sind,
- die Lagereinheiten (10) zumindest teilweise als Drehgelenke ausgebildet sind und ein drehender Teil (21) jedes Drehgelenks mit einer von einem Antrieb (5) betätigten Schubstange (4) zur lateralen Führung des Verfahrtisches (3) verbunden ist, sodass der Verfahrtisch (3) auf Basis eines durch die Schubstangen (4) gebildeten Koppelgetriebes in Form einer kartesischen Parallelkinematik über die Basisplatte (2) bewegbar ist, und
- die Schubstangen (4) hohl ausgebildet und Bestandteil der Absaugleitungen zum Abführen des Betriebsgases von den Lagereinheiten (10) sind,

2. Tischsystem nach Anspruch 1, **dadurch gekennzeichnet, dass** der Verfahrtisch (3) mit aerostatischen Lagereinheiten (10) und die Basisplatte (2) sowie ein Teil der Schubstangen (4) in einer ersten Vakuumkammer (6) aufgenommen sind und jeweils der Antrieb (5) zumindest teilweise zwischen der ersten Vakuumkammer (6) und einer zweiten Vakuumkammer (7) höheren Drucks angeordnet ist.

3. Tischsystem nach Anspruch 2, **dadurch gekennzeichnet, dass** die freien Enden der Schubstangen (4) jeweils in der zweiten Vakuumkammer (7) enden, die druckmäßig von der ersten Vakuumkammer (6) getrennt ist.

4. Tischsystem nach einem der Ansprüche 1 bis 3, **dadurch gekennzeichnet, dass** der Verfahrtisch (3) eine verwindungssteife Rahmenkonstruktion (8) umfasst, an der als Drehgelenke wirkende aerostatische Lagereinheiten (10) angebracht sind.

5. Tischsystem nach einem der Ansprüche 1 bis 4, **dadurch gekennzeichnet, dass** das drehbare Teil jeder das Drehgelenk umfassenden aerostatischen Lagereinheit (10) zu einem feststehenden Teil (14) über aerostatische Lagerelemente (22, 23) gelagert ist.

6. Tischsystem nach einem der Ansprüche 1 bis 5, **dadurch gekennzeichnet, dass** das feststehende Teil (14) im axialen Querschnitt eine T-Form, vorzugsweise eine Doppel-T-Form aufweist und das drehbare Teil ein um den mittleren Bereich als Achsenteil herum angeordneter drehbarer Ring (21) ist, der mindestens axial, vorzugsweise axial und radial zum feststehenden Teil (14) über aerostatische Lagerelemente (22, 23) gelagert ist.

7. Tischsystem nach einem der Ansprüche 1 bis 6, **dadurch gekennzeichnet, dass** die Absaugkanäle (16, 17) des Dichtsystems der aerostatischen Lagereinheiten (10) über Rohrleitungen (12) verbunden sind.

8. Tischsystem nach einem der Ansprüche 1 bis 5, **dadurch gekennzeichnet, dass** bei zweistufigen Dichtsystemen zum Abdichten gegen unterschiedliche Drücke zwei Schubstangen (4) das Gas mit niedrigerem Druck und eine Schubstange (4) das Gas mit höherem Druck führen.

9. Tischsystem nach einem der Ansprüche 1 bis 8,
**dadurch gekennzeichnet, dass** jede Schubstange (4) über eine Drehung und eine Torsion zulassendes Koppelelement (25) mit dem drehbaren Teil (21) der als Drehgelenk ausgebildeten aerostatischen Lagereinheit (10) verbunden ist.

10. Tischsystem nach einem der Ansprüche 1 bis 9, **dadurch gekennzeichnet, dass** an der der Basisplatte (2) zugewandten Rahmenkonstruktion (8) eine Vorspannvorrichtung, vorzugsweise eine elektrostatische Vorspannvorrichtung (11) zum Aufbringen einer zwischen Vorspannvorrichtung (11) und Basisplatte (2) wirkenden Kraft angeordnet ist.

11. Tischsystem nach einem der Ansprüche 1 bis 10, **dadurch gekennzeichnet, dass** der Antrieb (5) jeder Schubstange (4) ein von einem Motor angetriebenes, drehbar gelagertes Reibradgetriebe (26, 27, 28) aufweist.

12. Tischsystem nach einem der Ansprüche 1 bis 11, **dadurch gekennzeichnet, dass** zwischen erster und zweiter Vakuumkammer (6, 7) ein zumindest einstufiges, einen Dichtspalt (33) aufweisendes Dichtsystem ausgebildet ist.

13. Tischsystem nach Anspruch 12, **dadurch gekennzeichnet, dass** zwischen erster und zweiter Vakuumkammer ein zweistufiges Dichtsystem (33, 57; 34, 58) mit Zwischenabsaugung ausgebildet ist.

14. Tischsystem nach einem der Ansprüche 11 oder 13, **dadurch gekennzeichnet, dass** das Reibradgetriebe (26, 27, 28) ein inneres Gehäuseteil (26) und ein äußeres Gehäuseteil (27) umfasst, wobei das innere Gehäuseteil (26) im äußeren Gehäuseteil (27) drehbar gelagert ist.

15. Tischsystem nach Anspruch 14, **dadurch gekennzeichnet, dass** zwischen innerem und äußerem Gehäuseteil (26, 27) ein einstufiges Dichtsystem (55), vorzugsweise ein zweistufiges System (55, 56, 59) mit Zwischenabsaugung vorgesehen ist.

16. Tischsystem nach Anspruch 14 oder 15, **dadurch gekennzeichnet, dass** die Schubstange (4) durch das innere, vorzugsweise zylinderförmige Gehäuseteil (26) des Reibradgetriebes geführt und in diesem gelagert ist.

17. Tischsystem nach einem der Ansprüche 1 bis 16, **dadurch gekennzeichnet, dass** mindestens eine Schubstange (4) zum Zuführen von Medien zu dem Verfahrtisch (3) dient, wobei die Medien direkt über die hohle Schubstange oder über ein oder mehrere in der Schubstange geführte Leitungen zuführbar sind.

## Claims

1. Table system for vacuum application having a base plate and a moving table guided by aerostatic bearing units, wherein the bearing units are connected to supply lines and suction lines for supplying and extracting the operating gas required for the operation of the bearing units and are provided in each instance with a sealing system having at least one stage and comprising suction channel and sealing gap for sealing the bearing units relative to the vacuum, **characterized in that**
- at least three separate aerostatic bearing units (10) which have in each instance separate sealing systems with annular suction channels and sealing gaps are fastened to the periphery of the moving table (3),
- the bearing units (10) are constructed at least partially as swivel joints and a rotating part (21) of each swivel joint is connected to a push rod (4) which is actuated by a drive (5) for guiding the moving table (3) laterally, so that the moving table (3) is movable across the base plate (2) on the basis of a Cartesian parallel kinematics linkage formed by the push rods (4), and
- the push rods (4) are hollow and constitute a component part of the suction lines for extracting the operating gas from the bearing units (10).

2. Table system according to claim 1, **characterized in that** the moving table (3) with aerostatic bearing units (10), the base plate (2), and a portion of the push rods (4) are received in a first vacuum chamber (6), and the respective drive (5) is arranged at least partially between the first vacuum chamber (6) and a second vacuum chamber (7) having a higher pressure.

3. Table system according to claim 2, **characterized in that** the free ends of the push rods (4) terminate respectively in the second vacuum chamber (7) which is separated from the first vacuum chamber (6) with respect to pressure.

4. Table system according to one of claims 1 to 3, **characterized in that** the moving table (3) comprises a torsionally rigid frame construction (8) at which aerostatic bearing units (10) acting as swivel joints are arranged.

5. Table system according to one of claims 1 to 4, **characterized in that** the rotatable part of each aerostatic bearing unit (10) comprising the swivel joint is supported relative to a stationary part (14) by aerostatic bearing elements (22, 23).

6. Table system according to one of claims 1 to 5, **characterized in that** the stationary part (14) is T-shaped, preferably double-T-shaped, in axial cross section, and the rotatable part is a rotatable ring (21) which is arranged around the central area as axial part and which is supported at least axially, preferably axially and radially, relative to the stationary part (14) by aerostatic bearing elements (22, 23).

7. Table system according to one of claims 1 to 6, **characterized in that** the suction channels (16, 17) of the sealing system of the aerostatic bearing units (10) are connected by pipe lines (12).

8. Table system according to one of claims 1 to 5, **characterized in that** two push rods (4) conduct the gas at a lower pressure and one push rod (4) conducts the gas at a higher pressure in two-stage sealing systems for sealing against different pressures.

9. Table system according to one of claims 1 to 8, **characterized in that** each push rod (4) is connected to the rotatable part (21) of the aerostatic bearing unit (10) constructed as a swivel joint by a coupling element (25) which permits rotation and torsion.

10. Table system according to one of claims 1 to 9, **characterized in that** a preloading device, preferably an electrostatic preloading device (11), is arranged at the frame construction (8) facing the base plate (2) for applying a force acting between the preloading device (11) and the base plate (2).

11. Table system according to one of claims 1 to 10, **characterized in that** the drive (5) of each push rod (4) has a rotatably supported friction wheel gear unit (26, 27, 28) driven by a motor.

12. table system according to one of claims 1 to 11, **characterized in that** a sealing system comprising at least one stage and having a sealing gap (33) is formed between the first vacuum chamber (6) and second vacuum chamber (7).

13. stable system according to claim 12, **characterized in that** a two-stage sealing system (33, 57; 34, 58) with intermediate suction is formed between the first vacuum chamber and second vacuum chamber.

14. table system according to one of claims 11 or 13, **characterized in that** the friction wheel gear unit (26, 27, 28) comprises an inner housing part (26) and an outer housing part (27), wherein the inner housing part (26) is rotatably supported in the outer housing part (27).

15. Table system according to claim 14, **characterized in that** a single-stage sealing system (55), preferably a two-stage system (55, 56, 59) with intermediate suction, is provided between the inner housing part (26) and outer housing part (27).

16. Table system according to claim 14 or 15, **characterized in that** the push rod (4) is guided through the inner, preferably cylindrical, housing part (26) of the friction wheel gear unit and is rotatably supported therein.

17. Table system according to one of claims 1 to 16, **characterized in that** at least one push rod (4) serves to supply media to the moving table (3), wherein the media can be supplied directly through the hollow push rod or through one or more lines guided in the push rod.

## Revendications

1. Système de table pour l'utilisation sous vide avec une plaque de base et une table mobile guidée par des unités de palier aérostatiques, dans lequel les unités de palier sont reliées à des conduites d'alimentation et des conduites d'aspiration pour l'alimentation et l'extraction du gaz nécessaire pour l'opération des unités de palier et sont chacune équipées d'un système d'étanchéité au moins à une étape comprenant un canal d'aspiration et une fente d'étanchéité pour étancher les unités de palier par rapport au vide, **caractérisé en ce que**
- au moins trois unités de palier aérostatiques (10) séparées, qui ont chacune des systèmes d'étanchéité séparés avec des canaux d'aspiration annulaires et des fentes d'étanchéité, sont fixées à la périphérie de la table mobile (3),
- les unités de palier (10) sont construites au moins partiellement en tant que joints pivotants et une partie rotative (21) de chaque joint pivotant est reliée à une tige de poussée (4) qui est actionnée par un entraînement (5) pour guider la table mobile (3) latéralement, de telle sorte que la table mobile (3) est déplaçable sur la plaque de base (2) en raison d'un engrenage de couplage de cinématique parallèle cartésienne formé par les tiges de poussée (4), et
- les tiges de poussée (4) sont creux et constituent un élément des conduites d'aspiration pour extraire le gaz d'opération des unités de palier (10).

2. Système de table selon la revendication 1, **caractérisé en ce que** la table mobile (3) avec des unités de palier (10) aérostatiques, la plaque de base (2) et une partie des tiges de poussée (4) sont reçues dans une première chambre à vide (6), et l'entraînement (5) respectif est disposé au moins partiellement entre la première chambre à vide (6) et une deuxième chambre à vide (7) de pression plus élevée.

3. Système de table selon la revendication 2, **caractérisé en ce que** les extrémités libres des tiges de poussée (4) terminent chacune dans la deuxième chambre à vide (7) qui est séparée de la première chambre à vide (6) à ce qui concerne la pression.

4. Système de table selon une des revendications 1 à 3, **caractérise en ce que** la table mobile (3) comprend une construction à cadre (8) qui est résistante à la torsion, sur laquelle sont fixées des unités de palier (10) agissant comme joints pivotants.

5. Système de table selon une des revendications 1 à 4, **caractérise en ce que** la partie rotative de chaque unité de palier aérostatique (10) comprenant le joint pivotant est supporté par rapport à une partie fixe (14) par des éléments de palier aérostatiques (22, 23).

6. Système de table selon une des revendications 1 à 5, **caractérise en ce que** la partie fixe (14) a la forme d'un T, de préférence la forme d'un double T, dans la section transversale axiale, et la partie rotative est un anneau rotatif (21) qui est disposé autour de la zone centrale comme partie axiale et qui est supporté au moins axialement, de préférence axialement et radialement, par rapport à la partie fixe (14) par des éléments de palier aérostatiques (22, 23).

7. Système de table selon une des revendications 1 à 6, **caractérise en ce que** les canaux d'aspiration (16, 17) du système d'étanchéité des unités de palier aérostatiques (10) sont reliés par des tuyaux (12).

8. Système de table selon une des revendications 1 à 5, **caractérise en ce que** deux tiges de poussée (4) conduisent le gaz à une pression plus faible et une tige de poussée (4) conduit le gaz à une pression plus élevée dans des systèmes d'étanchéité à deux étapes pour assurer l'étanchéité contre des pressions différentes.

9. Système de table selon une des revendications 1 à 8, **caractérise en ce que** chaque tige de poussée (4) est reliée à la partie rotative (21) de l'unité de palier aérostatique (10) construit en tant que joint pivotant par un élément de couplage (25) qui permet la rotation et la torsion.

10. Système de table selon une des revendications 1 à 9, **caractérise en ce qu'**un dispositif de précontrainte, de préférence un dispositif de précontrainte (11) électrostatique, est disposé à la construction à cadre (8) face à la plaque de base (2) pour appliquer une force agissant entre le dispositif de précontrainte (11) et la plaque de base (2).

11. Système de table selon une des revendications 1 à 10, **caractérise en ce que** l'entraînement (5) de chaque tige de poussée (4) a un engrenage à roues de friction (26, 27, 28) supporté rotativement et entraîné par un moteur.

12. Système de table selon une des revendications 1 à 11, **caractérise en ce qu'**un système d'étanchéité comprenant au moins une étape et ayant une fente d'étanchéité (33) est formé entre la première chambre à vide (6) et la deuxième chambre à vide (7).

13. Système de table selon la revendication 12, **caractérise en ce qu'**un système d'étanchéité à deux étapes (33, 57; 34, 58) avec aspiration intermédiaire est formé entre la première chambre à vide et la deuxième chambre à vide.

14. Système de table selon une des revendications 11 ou 13, **caractérise en ce que** l'engrenage à roues de friction (26, 27, 28) comprend une partie de boîtier intérieure (26) et une partie de boîtier extérieure (27), la partie de boîtier intérieure (26) étant supportée rotativement dans la partie de boîtier extérieure (27).

15. Système de table selon la revendication 14, **caractérise en ce qu'**il y a un système d'étanchéité à une seule étape (55), de préférence un système à deux étapes (55, 56, 59) avec aspiration intermédiaire, entre la partie de boîtier intérieure (26) et la partie de boîtier extérieure (27).

16. Système de table selon la revendication 14 ou 15, **caractérise en ce que** la tige de poussée (4) est guidée à travers la partie de boîtier intérieure (26), de préférence cylindrique, de l'engrenage à roues de friction et supportée rotativement dans celle-ci.

17. Système de table selon une des revendications 1 à 16, **caractérisé en ce que** au moins une tige de poussée (4) sert à alimenter des milieux vers la table mobile (3), dans lequel les milieux peuvent être alimentés directement par la tige de poussée creuse ou par une ou plusieurs conduites guidées dans la tige de poussée.
